# EUROPEAN PATENT SPECIFICATION

(11) **EP 1 974 399 B1**
(45) Date of publication and mention of the grant of the patent: **11.08.2010**
(21) Application number: 06831466.5
(22) Date of filing: 22.12.2006
(51) Int. Cl.: H01L 51/00, H01L 51/42, H01L 51/50

(54) **IMPROVED CARBON NANOTUBE BASED SEMICONDUCTING DEVICES AND METHODS FOR THEIR PRODUCTION**
VERBESSERTE HALBLEITERANORDNUNGEN AUF KOHLENSTOFF-NANORÖHRENBASIS UND VERFAHREN ZU IHRER HERSTELLUNG
DISPOSITIFS SEMI-CONDUCTEURS A BASE DE NANOTUBES DE CARBONE AMELIORES ET LEURS PROCEDES DE FABRICATION

(30) Priority: 29.12.2005 GB 0526572
(43) Date of publication of application: 01.10.2008
(73) Proprietor: The University of Surrey, Guildford, Surrey GU2 5XH (GB)
(72) Inventor: HATTON, Ross, Andrew, Surrey GU2 7XH (GB); SILVA, Sembukutiarachilage, Ravi, Surrey GU15 2ND (GB); HENLEY, Simon, John, Surrey GU2 7XH (GB)
(74) Representative: Gray, Peter John Bracey
(86) International application number: PCT/GB2006/004908
(87) International publication number: WO 2007/074339

(56) References cited:
- EP-A- 1 507 298
- WO-A-2007/007061
- US-A1- 2004 183 070
- TASIS DIMITRIOS ET AL: "Soluble carbon nanotubes" CHEM. EUR. J.; CHEMISTRY - A EUROPEAN JOURNAL SEP 5 2003, vol. 9, no. 17, 5 September 2003 (2003-09-05), pages 4000-4008, XP008075908
- ZHAO JIJUN ET AL: "Electronic Properties of Carbon Nanotubes with Covalent Sidewall Functionalization" J PHYS CHEM B; JOURNAL OF PHYSICAL CHEMISTRY B APR 8 2004, vol. 108, no. 14, 8 April 2004 (2004-04-08), pages 4227-4230, XP002422970
- MILLER A J ET AL: "Interpenetrating multiwall carbon nanotube electrodes for organic solar cells" APPLIED PHYSICS LETTERS AIP USA, vol. 89, no. 13, 25 September 2006 (2006-09-25), pages 133117-1, XP008075860 ISSN: 0003-6951

## Description

The present invention relates to improved photo-voltaic or light emitting devices and methods for their production. In particular, the present invention relates to a method wherein carbon nanotubes are combined with a selected semiconductor organic material to form a composite material.

It should be noted that in this application carbon nanotube (CNT) is intended to mean single walled conducting, or semi-conducting carbon nanotubes (SWCNT), multi-walled carbon nanotubes (MWCNT) or a mixture of both. It should also be noted that this invention is not restricted to any particular length or diameter CNT. Furthermore, since carbon nanotubes may be synthesised by several different methods (e.g. chemical vapour deposition (CVD), arc discharge and laser ablation methods) it should be noted that this application is not limited to any particular method of carbon nanotube production.

It should also be noted that in this application organic matrix is intended to mean organic semiconductor of molecular, oligomer or polymeric type or any mixture thereof. Furthermore, the organic matrix may also mean one or more organic semiconductor in combination with one or more insulating organic material.

A great deal of research and development has been carried out in the area of carbon nanotube production. The applicant has previously filed patent applications associated with carbon nanotube production. One such application (PCT/GB02/003438 (WO03/011755)) relates to the production of carbon nanotubes at low temperatures improving compatibility with organic materials such as plastics.

A large amount of research and development has taken place into organic semiconductor materials and devices. The applicant has previously filed a patent application associated with composites of organic semiconductors and carbon nanotubes (UK Patent Application No. 0514038.9), relating to a method of producing a thin film of organic semiconductor with uniformly dispersed carbon nanotubes and devices incorporating such a thin film.

Organic semiconductors can be processed into large area thin films at room temperature using spin coating or printing techniques, making them attractive as the basis for low cost electronic devices, such as solar cells and light-emitting diodes. Whilst organic light-emitting diodes have now entered the market place in niche applications, the ultimate goal of large area displays and white light sources for general illumination cannot be realised without further improvements in device performance. If organic solar cells are to achieve their potential as a clean low cost energy solution the power conversion efficiency and operational stability must be improved, whilst retaining the cost advantages of solution processing. Whilst conventional silicon solar cells exhibit high efficiencies and device durability, the fabrication costs are prohibitively high. In view of the urgent global need for clean, low cost energy solutions, solar cells are one of the most important potential applications of organic semiconductors.

It is widely known that carbon nanotubes quench photo-luminescent emission from organic materials when combined to form a composite material. That is, the photo-luminescent properties of organic materials are diminished when combined with carbon nanotubes to form a composite.

It is known that carbon nanotubes are visible photo-luminescent materials when excited with coherent (laser) light. That is, carbon nanotubes efficiently absorb ultra-violet, visible, or infra-red light causing them to emit visible light. Typically the energy of the absorbed light is greater than the emitted light. However, it is also possible that the energy of the absorbed light is less than the energy of the emitted light, in which case the absorption process is described as multi-photon absorption. Photo-luminescence from carbon nanotubes is generally limited to isolated carbon nanotubes, supported on a solid substrate or suspended in solution.

It is also known that visible photo-luminescence from carbon nanotubes can be greatly enhanced by functionalising the outer surface. Enhanced visible luminescence of carbon nanotubes by chemically modifying the outer surface is believed to be mediated by defects formed during functionalisation and is not limited to specific functionality. It is important to note that visible photo-luminescence from adapted carbon nanotubes is distinct from photo-luminescence from visible chromophores attached to carbon nanotubes.

It is known to manufacture devices using thin film organic semiconductor layers, such as organic solar cells (photovoltaic devices) and organic light-emitting diodes. For these applications the low charge carrier mobility (10⁻⁶ cm² V⁻¹ s⁻¹ to 10⁻¹ cm² V⁻¹ s⁻¹) in organic semiconductors necessitates the use of very thin layers of these materials (< 200 nm). In organic solar cells the requirement to use very thin organic films limits the light absorption. This problem is exacerbated by the limited range of wavelengths over which organic semiconductors absorb. These factors severely limit the efficiency of organic solar cells because a large part of the solar spectrum is not used to generate electrical energy.

In research by Li et al. (Materials Chemistry and Physics 2004 vol. 88 pp. 53-58) the fabrication of a composite material of adapted carbon nanotubes and polyacrylamide is documented. This research aims to improve the load-bearing and anti-wear properties of polyacrylamide thin films. It is documented that visible PL from polyacrylamide is weakly enhanced - by a factor of 1.6 - when combined with adapted carbon nanotubes to form a composite material. Such a weak effect can be attributed to scattering of the excitation light and shows that the energy levels in the organic matrix material do not enable efficient energy transfer from the adapted carbon nanotube to the polymer matrix. Also the polymer used in this study is an insulator, rendering it unsuitable as an active component in optoelectronic device applications.

It is also known that coloured organic materials, particularly organic semiconductors, can be susceptible to photo-bleaching. That is, prolonged exposure to light causes the degradation of the chromorphoric moieties within the organic material, such that their absorption and/or emission characteristic is irreversibly degraded. The susceptibility of organic semiconductors to photo-bleaching is a major limiting factor in the realisation of commercially viable organic solar cells which must be stable towards intense solar radiation for many years.

EP-A-1507298, over which the present invention is characterized, describes a photovoltaic device comprising a composition of carbon nanotubes and an organic compound. In one example, the organic compound is a conjugated organic semiconducting polymer, the band gap of the carbon nanotubes lies in the range 0.5-1.0 eV and the band gap of the polymer lies in the range of 1-3 eV.

The present invention aims to overcome, at least alleviate, the aforementioned problems.

In one aspect the present invention provides a method of producing a photo-voltaic device comprising the steps of: synthesising carbon nanotubes; and combining the carbon nanotubes and an organic semiconductor material to form a composite material, characterised by adapting the synthesised carbon nanotubes to provide a surface defect such as to create an effective band gap defined by ground and excited electronic states; selecting the organic semiconductor material to facilitate the efficient energy transfer between carbon nanotubes and the organic semiconductor material, wherein the organic semiconductor material is selected such that the highest occupied molecular orbital (HOMO) and lowest unoccupied molecular orbital (LUMO) energy levels of the organic semiconductor material lie between the energy levels of the ground and excited electronic states of the adapted carbon nanotubes.

In a further aspect, the present invention provides a method of producing a light emitting device comprising the steps of: synthesising carbon nanotubes; and combining the adapted carbon nanotubes and the selected organic semiconductor material to form a composite material, characterised by adapting the synthesized carbon nanotubes to provide a surface defect such as to create an effective band gap defined by ground and excited electronic states; selecting the organic semiconductor material to facilitate the efficient energy transfer from the organic semiconductor material to the adapted carbon nanotubes, wherein the organic semiconductor material is selected such that the energy levels of the ground and excited electronic states of the adapted carbon nanotubes lie between the HOMO and LUMO energy levels of the organic semiconductor material;.

In yet a further aspect, the present invention provides a photo-voltaic device comprising carbon nanotubes embedded in an organic semiconductor material, characterised by the carbon nanotubes being adapted to provide a surface defect such as to create an effective band gap defined by ground and excited electronic states, where the HOMO and LUMO energy levels of the organic semiconductor material lie between the energy levels of the ground and excited electronic states of the adapted carbon nanotubes.

In yet a further aspect, the present invention provides a light emitting device comprising carbon nanotubes embedded in an organic semiconductor material, characterised by the carbon nanotubes being adapted to provide a surface defect such as to create an effective band gap defined by ground and excited electronic states, where the energy levels of the ground and excited electronic states of the adapted carbon nanotubes lie between the HOMO and LUMO energy levels of the organic semiconductor material.

Adapted carbon nanotubes embedded within an organic host matrix can be stimulated into an electronically excited state in one of two ways: (i) Direct optical excitation using coherent and/or incoherent light, where adapted carbon nanotubes supported within an organic host matrix can be electronically excited through the absorption of ultra-violet, visible or infra-red light; (ii) In-direct electrical excitation - That is, by application of an electric field the organic host can be electrically excited via the injection of both negative (electrons) and positive (holes) charge carriers, which upon arrival at a carbon nanotube within the organic matrix form an electronically excited state on said carbon nanotube. Throughout this application the energy gap between the energy levels comprising the ground and excited states on adapted carbon nanotubes is described as the *effective band* gap of the adapted carbon nanotube. It should also be understood that the ground and excited electronic states of adapted carbon nanotubes comprise a distribution of states.

Energy may be transferred between the organic matrix and carbon nanotube in either direction, depending on the application, by; (i) the coherent transfer of an electron and hole pair (Dexter transfer); (ii) sequential transfer of an electron and hole (charge transfer); (iii) resonant coupling transfer (Förster transfer); or any combination of (i)-(iii). Further it will be understood that in this application the term *energy transfer* is used to mean complete or partial transfer of energy.

Further, the carbon nanotubes embedded within the organic matrix retard photo-degradation of the organic matrix, thereby extending lifetime of the organic matrix.

Further, the carbon nanotubes embedded within the organic matrix retard thermal degradation of the organic matrix by improving thermal management within the composite, thereby extending the lifetime of the organic matrix and the device in which it is utilised. The improved thermal management in said materials also enables their utilisation in high power devices.

This invention represents a significant advance in materials technology, enabling improved performance of electronic devices employing organic semiconductors. More specifically this invention increases the prospects for the commercial exploitation of organic solar cells; the solar cells offering enhanced efficiency, good operational stability and large area, low-cost deposition capability using solution processing techniques such as inkjet printing or spin-coating.

This invention also increases the prospects for the commercial exploitation of organic light-emitting diodes for large area flat panel displays and general illumination; the diodes offering good operational stability and large area, low cost deposition capability.

Carbon nanotubes have enormous potential as part of a composite with organic materials, particularly in organic solar cells. These materials offer:
i. enhanced power conversion efficiencies due to greater utilisation of the solar spectrum, by employing carbon nanotubes, or in conjunction with, organic semiconductors to harvest incident photons.
ii. improved resistance to photo-bleaching of the organic matrix, thereby extending device lifetime.
iii. enhanced device lifetime, since carbon nanotubes as light absorbers are less susceptible to physical and chemical degradation than organic semiconductors.
iv. enhanced trapping of light in solar cells, owing to the propensity of carbon nanotubes to scatter light.
v. versatility due to the ability to tune the electronic and optical properties of both the organic matrix and carbon nanotubes, thereby maximising potential applications.
vi. compatibility with flexible low cost substrates and existing low cost, large area solution processing technologies.
vii. improved thermal management within the organic matrix, owing to the high thermal conductivity of carbon nanotubes, which retards thermal degradation of the organic matrix extending the lifetime of the organic matrix and devices in which it is utilised.
viii. improved thermal management within the organic matrix, owing to the high thermal conductivity of carbon nanotubes, minimising any heat induced reduction in exciton diffusion length or charge carrier mobility within the organic host, thereby helping to maintain the efficiency of solar cell devices in which the composite is utilised.

Carbon nanotubes also have enormous potential as part of a composite with organic materials, in organic light emitting diodes for flat panel displays and general illumination. These materials offer.
i. broad band visible light emission due to the luminescent properties of adapted carbon nanotubes.
ii. improved resistance to photo-bleaching of the organic matrix, thereby extending device lifetime.
iii. enhanced device lifetime, since carbon nanotubes as light emitters are less susceptible to physical and chemical degradation than organic semiconductors.
iv. versatility due to the ability to tune the electronic and optical properties of both the organic matrix and carbon nanotubes, thereby maximising potential applications.
v. compatibility with flexible low cost substrates and existing low cost, large area solution processing technologies.
vi. improved thermal management within the organic matrix, owing to the high thermal conductivity of carbon nanotubes, which retards thermal degradation of the organic matrix. In OLED applications improved thermal management allows the device to sustain high current densities increasing device brightness and efficiency.
vii. improved thermal management within the organic matrix, owing to the high thermal conductivity of carbon nanotubes, minimises any reduction in charge carrier mobility within the organic host matrix resulting from heating.
viii. The potential to for highly polarized light by aligning the carbon nanotubes within the organic host matrix.

Specific embodiments of the present invention will now be described by way of example only, with reference to the accompanying drawings, in which:
Figure 1 shows a scanning electron microscope image of purified MWCNT;
Figure 2 shows a photoluminescence spectrum of a pure nylon 10,10 film using 488 nm excitation;
Figure 3 shows photoluminescence spectra of nylon 10,10:MWCNT composites with MWCNT weight percentages of 5%, 10% and 30%, using an excitation wavelength of 488 nm;
Figure 4 shows a graph of the integrated photoluminescence intensity from nylon 10,10:MWCNT composites as a function of weight percentage MWCNT, using an excitation wavelength of 488 nm;
Figure 5 shows a photoluminescence spectrum of a nylon 10,10 film using 325 nm excitation;
Figure 6 shows a typical photoluminescence spectra of a nylon:MWCNT composite with a MWCNT weight percentage of 15%, using an excitation wavelength of 325 nm;
Figure 7 shows a graph of the absorbance of an acid treated MWCNT thin film as a function of wavelength;
Figure 8 shows a graph of the absorbance as a function of wavelength for nylon 10,10:MWCNT composites with MWCNT weight percentages of: (a) 5%; (b) 2.5%; and (c) 0%.
Figure 9 shows photo-luminescent decay curves for a nylon 10,10:MWCNT composite with MWCNT weight percentage of 30% (i) and for pure nylon (ii).
Figure 10 shows photoluminescence spectra obtained using 488 nm excitation of a nylon 10,10:MWCNT composite with MWCNT weight percentage of 30%. The series corresponds to spectra recorded after exposures of 1 minute (i); 4 minutes (ii); 8 minutes (iii); 11 minutes (iv); and 40 minutes (v);
Figure 11 shows a simplified energy level diagram of the process of photo-induced electronic excitation of the MWCNT and the subsequent processes of energy transfer from the MWCNT to an emissive centre in the adjacent organic matrix and emission from said emissive centre;
Figure 12A shows a schematic diagram of a multi-layer organic solar cell (OSC) device;
Figure 12B shows a schematic energy level diagram corresponding to the device of Figure 12A;
Figure 13A shows a schematic diagram of a multi-layer organic light-emitting diode (OLED);
Figure 13B shows a schematic energy level diagram corresponding to the device of Figure 13A;

### FIRST EMBODIMENT

In this embodiment adapted carbon nanotubes embedded within an organic semiconductor matrix are stimulated into an excited electronic state by coherent visible and ultra-violet light. It should however by noted that in this invention optical excitation of adapted carbon nanotubes may be achieved using coherent light (e.g. laser light) and/or incoherent light (e.g. sun light). The optically excited carbon nanotubes then transfer the excitation energy, at least in part, to emissive centers in the organic matrix which subsequently return to the ground state with the emission of visible light. In this embodiment the light emitted by the organic host matrix is of lower energy than that absorbed by the adapted carbon nanotubes. That is, in this embodiment the composite of adapted carbon nanotubes and organic matrix functions as an ultra-violet and visible light down converter.

There are several stages required in order to produce a composite material where carbon nanotubes are dispersed within a matrix of organic semiconductor material: (i) carbon nanotube synthesis; (ii) carbon nanotube purification; (iii) carbon nanotube adaptation to enhance luminescent properties; (iv) judicious selection of the organic semiconductor material; (v) combining the adapted carbon nanotubes with the organic semiconductor material.

The first stage is to grow carbon nanotubes using any known carbon nanotube growth method. As discussed above, carbon nanotubes may be synthesised by several different methods including chemical vapour deposition (CVD), arc discharge and laser ablation methods. It will be understood that the low temperature carbon nanotube growth process described in patent application: PCT/GB02/003438 (WO03/011755) could be utilized to provide vertically aligned highly ordered arrays of high purity carbon nanotubes on solid substrates. Crucially carbon nanotubes grown at low temperature are intrinsically more defective than those grown at high temperature making them easier to chemically adapt. In this embodiment, the MWCNT are utilised and grown using any known high temperature (> 500 °C) CVD method.

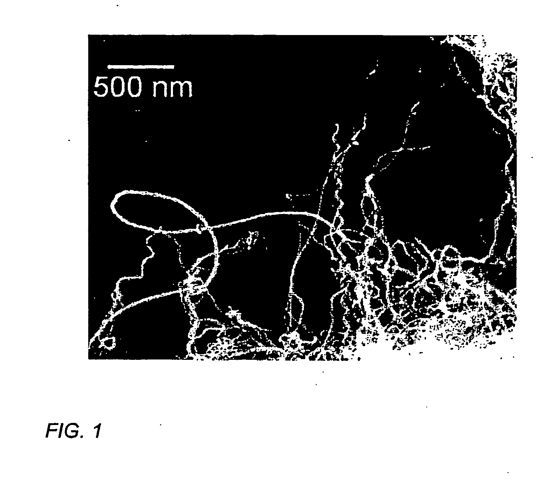

The resultant carbon nanotubes are then purified to remove amorphous carbon, carbon shells, fullerenes and metal catalyst particles. In this embodiment, the carbon nanotubes are purified by repeated washing with hydrochloric acid followed by washing with purified de-ionised water. However, it should be noted that the invention is not limited to any particular method of carbon nanotube purification. Figure 1 shows an SEM image of the MWCNT used in this embodiment. The high purity of the sample is evident, since no large amorphous carbon or metal impurities are visible.

To improve compatibility with the organic matrix and to enhance the luminescent properties, carbon nanotubes are adapted on the outer surface. In this embodiment, the MWCNT are firstly oxidised in a 3:1 mixture of concentrated sulphuric and nitric acid to produce surface carboxylic acid functionality. In a typical acid-oxidation treatment 10 g of pristine MWCNT are added to a 200 ml mixture of concentrated sulfuric and nitric acids (volume 3:1, 98% and 60% respectively). The mixture is then ultra-sonically agitated at 40 kHz for 30 minutes before stirring for 2 hours at 135°C. The mixture is then diluted ten-fold with de-ionised water and vacuum filtered using an 0.22 µm polycarbonate membrane filter. The solid is then washed repeatedly with distilled water until the pH value of the filtrate is 7. The filtered solid is dried under vacuum for 12 hours at 60°C, affording 5.8g of oxidized MWCNT. Once purified and acid functionalised the carbon nanotubes are combined with the organic matrix by synthesis of the organic material *in-situ* with carbon nanotubes. In this embodiment the polymer is synthesised from the diacid and diamine precursors in the presence of the acid functionalised MWCNT: Typically 36g grams of the monomer salts, prepared by the recrystallisation of the diacid (1,10-decanedioic acid) and diamine (1,10-diaminodecane) monomers are heated in a nitrogen atmosphere at 190°C for two hours. Then the previously acid-oxidised MWCNT (4 grams) are added and heated under vacuum at 225°C for 4 hours. In this way the acid functionalised MWCNT are further functionalised with nylon 10,10 (polyamide) moieties attached by amide linkages. The solid composite therefore comprises MWCNT functionalised with nylon moieties and any unreacted functionality from the previous acid oxidation (e.g. carboxylic acid moieties) within a matrix of nylon 10,10.

It should be noted that this invention is not limited to any particular type of functionality or method of attachment to the carbon nanotube. It should also be noted that in this invention the carbon nanotubes can be adapted *in-situ* with the synthesis of the organic matrix, as described in this embodiment, or adapted in an entirely separate process and simply blended with the organic matrix to form a composite of adapted carbon nanotubes dispersed within the organic host.

A component of the organic matrix material is selected by selecting the energy gap between the highest occupied molecular orbital (HOMO) and lowest unoccupied molecular orbital (LUMO) such that it lies between the ground state and the excited electronic state of an electronic excitation on the modified carbon nanotube. The excited electronic state on the carbon nanotube is associated with a defective carbon nanotube. The organic material is selected such that electronically excited carbon nanotubes can return to the ground state by transferring the excitation energy, at least in part, to the organic matrix, inducing an electronic excitation in the organic matrix.

Composites of the MWCNT and nylon prepared using this method remain electrically insulating even up to 30% MWCNT by weight, indicating that the MWCNT do not form a continuous interpenetrating network, but are largely electrically isolated. For MWCNT loading <10% w/w the composites were semi-transparent.

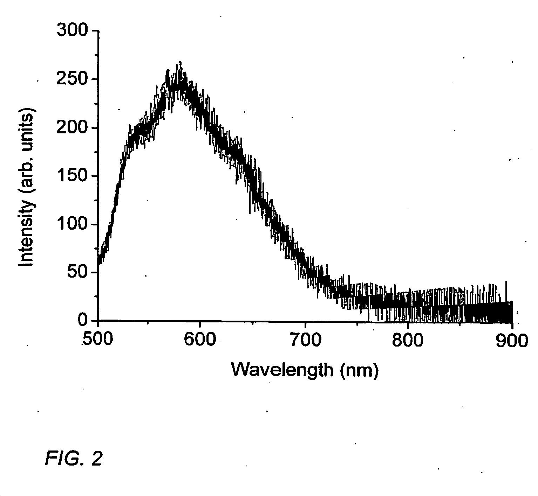

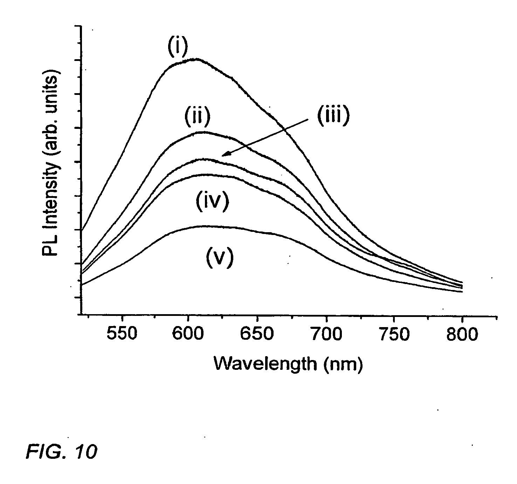

In this embodiment the organic matrix, nylon 10,10, contains a small amount of intrinsic emissive centers within a non-emissive bulk. The number density of these emissive centers is very low (< 0.001%), consequently photoluminescence is only observed for very intense excitation radiation. Whilst the exact structure of the emissive centers in nylon remains the subject of debate, it is widely accepted that they are formed during nylon synthesis and are not confined to one structural form. In this embodiment these luminescent centers correspond to the organic semiconductor component of the organic matrix to some of which energy is transferred from adapted CNT. Figure 2 shows the photo-luminescence spectrum of a nylon 10,10 sample using light of 488 nm excitation. The shoulders on the PL band centered at ∼ 580 nm indicate that it is the superposition of a number of contributions from different emissive centers. After prolonged exposure to the intense laser light (> 5 min) the shape of this PL feature begins to change (Figure 10), indicative of photo-bleaching. The photo-luminescence band at ∼ 580 nm is therefore attributed to two or more structurally related nylon impurities, each with a different susceptibility to photo-bleaching.

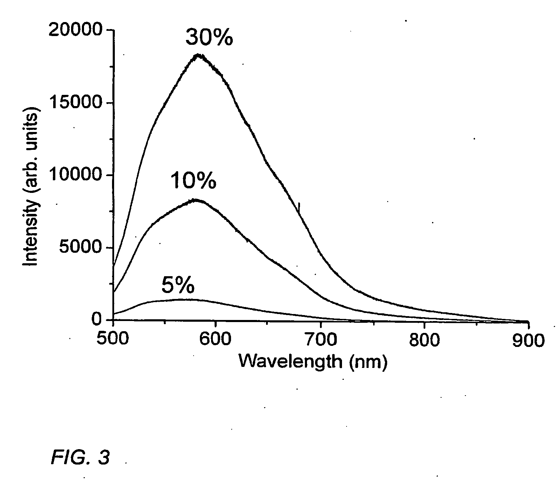

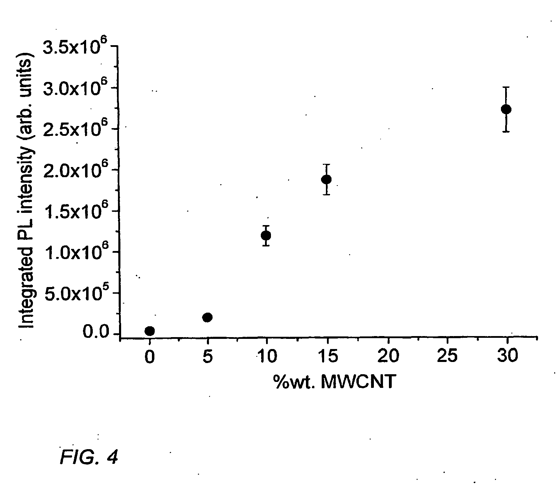

Figure 3 shows the photo-luminescence spectrum of the nylon:MWCNT composites for 488 nm excitation as a function of MWCNT weight percentage. For all MWCNT concentrations the strong band at -580 has the same position, full-width-at-half-maximum and form as the very weak band observed for the pure nylon sample. This indicates that the same luminescent centers are responsible for the photo-luminescent emission, rather than new luminescent centers formed during nylon synthesis in the presence of MWCNT. A plot of the integrated photoluminescence intensity for the 488 nm excitation as a function of the weight percentage incorporation of MWCNT is shown in Figure 4. A dramatic increase in the photo-luminescent intensity by two orders of magnitude is observed as the weight percentage of MWCNT increases from 0 to 30%. This indicates that adapted MWCNT absorb 488 nm light and efficiently transfer the excitation energy to emissive centers intrinsic to the nylon matrix, inducing an electronic excitation in said emissive centers, which subsequently relax to the ground state with the emission of visible light. Above 30% the increase in the photoluminescence signal begins to saturate. Since the band at ∼580 nm originates from emissive centers intrinsic to nylon, progressively reducing the fraction of nylon in the composite reduces the number of emissive centers, ultimately curtailing the luminescent intensity. Consequently, the emission intensity begins to saturate near to 30 % MWCNT. Time resolved photoluminescence found the decay time for emission detected at ∼580 nm from the nylon: 30% MWCNT sample to be less than 60 ns, indicative of fluorescent, rather than phosphorescent emission.

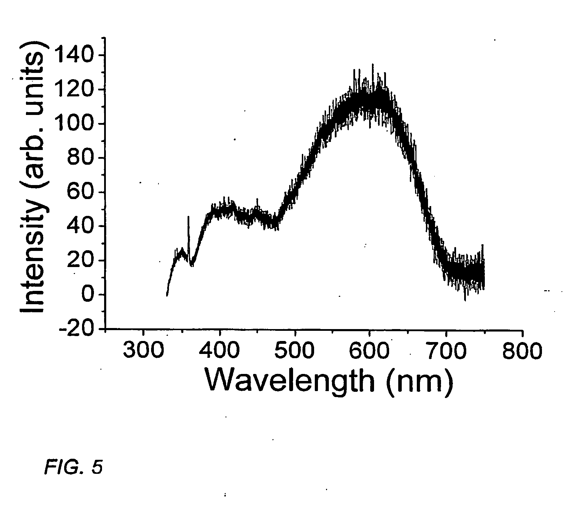

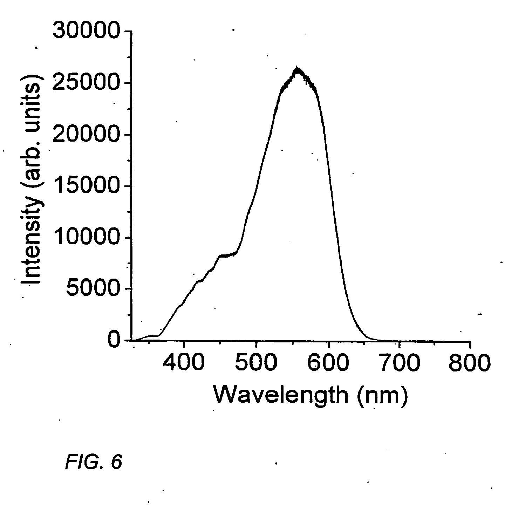

Figure 5 shows the photo-luminescence spectrum of a nylon 10:10 sample for 325 nm excitation. Figure 6 shows the photoluminescence spectrum of the nylon:MWCNT composite comprising 15 % MWCNT, also excited with 325 nm light. The band between 325 and 700 nm from the nylon sample is clearly comprised of a number of distinct peaks indicative of several different emissive centers. Notably, the maximum in the spectrum of the nylon:MWCNT composite, ∼ 550 nm, does not correlate with maximum in the photo-luminescence spectrum of nylon, ∼600 nm. However, enhancement of the weak bands between 325-475 nm in the nylon spectrum is clearly evident as a high energy shoulder in spectrum shown in Figure 6. This result is evidence that MWCNT absorb the incident 325 nm light and efficiently transfer the excitation energy to emissive centers intrinsic to the nylon matrix, inducing an electronic excitation in said emissive centers, which subsequently relax to the ground state with the emission of visible light. There is no evidence for enhancement of the band at ∼ 600 nm (i.e. no shoulder). This is because energy transfer can only occur when the ionisation energy and lowest excited state of the luminescent center are located between the energy states of the electron and hole comprising the excitation on the MWCNT. Consequently, energy cannot be coupled to all potentially emissive centers in the nylon matrix, explaining the absence of any enhancement in the peak at 600 nm for 325 nm excitation. The new peak at ∼550 nm in the photo-luminescence spectrum obtained for 325 nm excitation (Figure 6) is attributed to luminescence from adapted MWCNT, rather than emissive centers intrinsic to nylon. An integrated intensity verses MWCNT loading relationship similar to that for 488 nm excitation can be obtained (not shown).

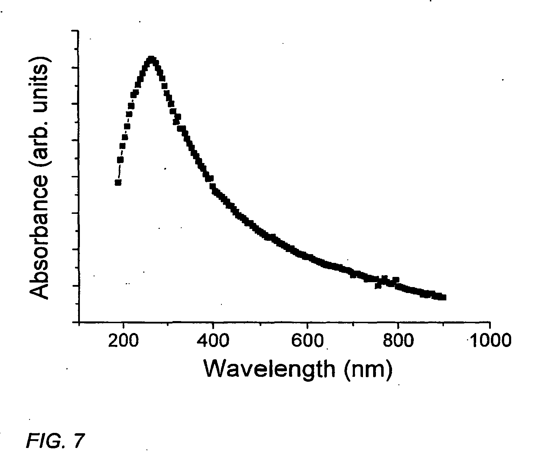

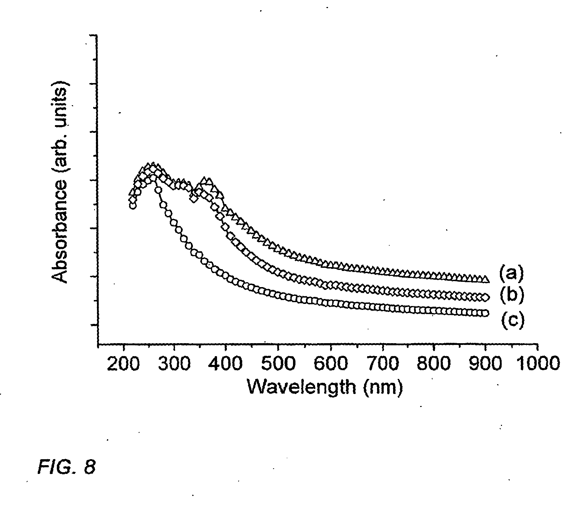

Figure 7 shows the optical absorption characteristics for a thin film of acid functionalized MWCNT supported on quartz. The optical absorption properties of the samples measured as a function of MWCNT loading is shown in Figure 8. MWCNT absorb throughout the measured energy range with a peak maxima at ∼269 nm assigned to the π-π* optical transition from the density of states previously identified [H. Ago et al. Journal of Physical Chemistry B 1999 pp. 8116-8121]. The spectrum of nylon (Figure 8(c)) has a very similar shape to that of MWCNT (Figure 7), with a peak maximum at ∼260 nm. Apart from the broad maxima at 260-270 nm characteristic of the nylon, there are two additional peaks in the absorption spectra of the composite (Figures 8(a) and 8(b)) at ∼ 320 nm and ∼366 nm, evidence of a ground state electronic interaction between the acid oxidised MWCNT and nylon matrix. Functionalising the outer surface of MWCNT with organic molecules is known to red shift the π-π* optical absorption maxima of MWCNT by as much as 80 nm indicating the formation of a broad continuum of new states with bonding and anti-bonding energies comparable to those of the π and π* molecular orbitals in pristine MWCNT. The two new peaks in the absorption spectrum of the composite are therefore attributed to the optical absorption maxima of MWCNT functionalised in two chemically distinct ways within the nylon matrix: (i) covalent functionalisation of the carbon nanotube surface with nylon chains tethered to the nanotube surface via amide linkages; (ii) non-covalent acid-base interaction between the imine nitrogens on nylon and the carboxylic acid functionality on the oxidised MWCNT surface. Importantly, irrespective of their origin, neither of these new peaks in the adsorption spectrum of the composite can account for the greatly enhanced PL emission using 488 nm excitation.

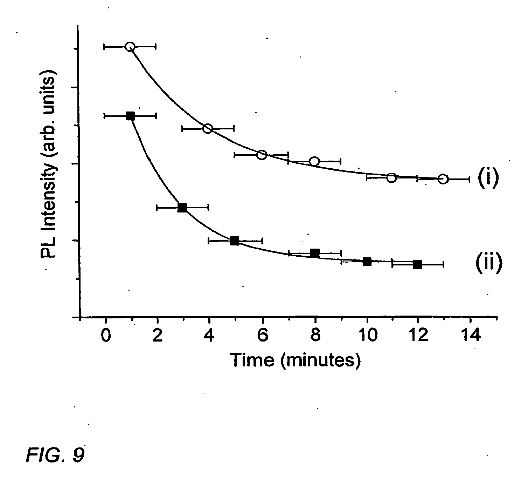

The fluorescence and phosphorescence from polymer systems is often observed to suffer from photo-bleaching. In this process the intensity of the luminescence permanently decays with exposure to light. For the samples presented here, the fluorescence was also observed to decay with exposure to 325 nm and 488 nm laser photons. Figure 9 shows plots of the photo-luminescence intensity decay due to photo-bleaching during 488 nm laser exposure of a 30 % MWCNT:nylon composite. In Figure 10 a series of PL spectra are displayed, taken after exposures of 1 minute (i), 4 minutes (ii), 8 minutes (iii), 11 minutes (iv) and 40 minutes (v). In addition to a decrease in the luminescence intensity, a change in the shape of the emission band is observed. This change in shape, which leads to a red-shift in the band, is due to different rates of photo-bleaching of the different emission feature that constitute the emission band. To compare the rate of photo-bleaching for the pure polymer and the composite, the integrated intensity of the photo-luminescence spectra was measured as a function of exposure time t. Figure 9 shows two such decay curves: (i) 30% MWCNT:nylon composite; (ii) pure polymer. The decay constants *t*ₒ, assumes an exponential of the form *exp(-t*/*tₒ),* for the composite and the polymer are 3.3 ± 0.3 and 2.1 ± 0.1, respectively. These values indicate that the composites have increased resistance to photo-bleaching. It is likely that the high thermal conductivity of MWCNT facilitates enhanced thermal management within the polymer film.

In summary, this embodiment shows that adapted MWCNT can absorb light of 325 nm and 488 nm and efficiently transfer the excitation energy to selective emissive centers intrinsic to the nylon 10,10 host matrix, inducing an electronic excitation in said emissive centers.

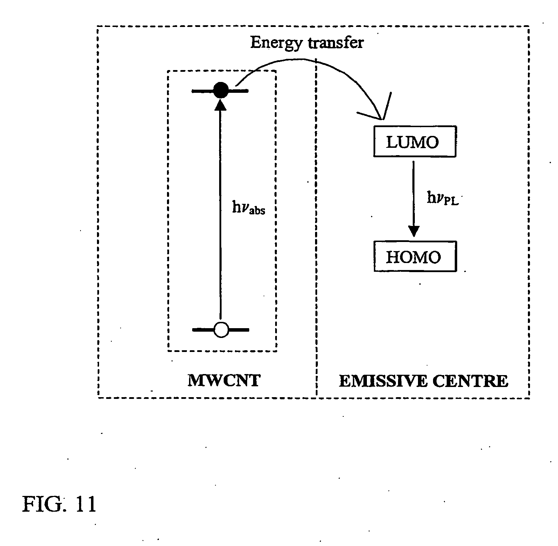

Furthermore, this embodiment shows that the process of energy transfer from an optically excited MWCNT to a surrounding organic matrix can only occur when the highest occupied molecular orbital (HOMO) and lowest unoccupied molecular orbital (LUMO) of the emissive (fluorescent) centre are located between the energy states of the electron and hole comprising the excitation on the MWCNT. This process is illustrated schematically in Figure 11. It should be noted that in Figure 11 only one discrete ground and excited electronic state associated with the defective carbon nanotube is shown. In reality there is a distribution of ground and excited electronic states associated with each adapted CNT.

The results in the first embodiment were obtained from samples containing fluorescent species incorporated at extremely low levels. By purposely introducing higher concentrations of selected fluorescent molecules much higher luminescent intensities would be expected. In this way MWCNT could be utilised in place of, or in combination with, strongly absorbent organic semiconductors to harvest solar radiation in organic solar cells.

This embodiment also demonstrates that MWCNT embedded within an organic matrix can retard photo-bleaching of the organic matrix, thereby helping to preserve the electronic properties of the organic matrix against the detrimental effect of prolonged exposure to light.

### SECOND EMBODIMENT

Fabrication of an organic solar cell utilising this invention:
Organic solar cells comprise one or more semiconducting organic film(s) sandwiched between two electrodes. Each film may comprise a single material or a composite of two or more different materials.

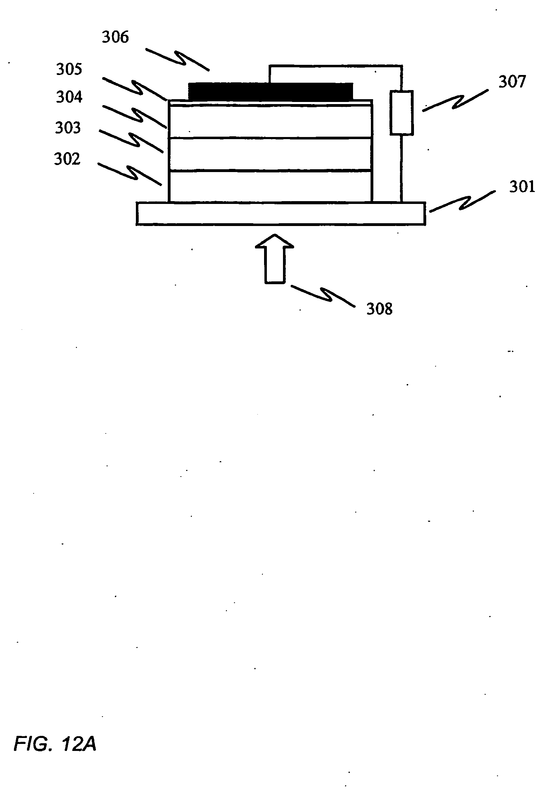

Figure 12A shows a schematic of a heterojunction organic solar cell device according to this embodiment The device comprises a transparent anode 301, made of Indium-tin Oxide (ITO) coated glass with a sheet resistance of < 100 Ohms per square. The ITO coating on the glass substrate is typically 100-300 nm thick. In should be understood that any semi-transparent conducting substrate may be used as the transparent electrode, including conducting polymer-carbon nanotube composites such as poly(3,4-ethylene dioxy-2,4-thiophene)-polystyrene sulfonate (PEDOT:PSS)-MWCNT composites, where a continuous network of MWCNT within the conducting polymer film serves to enhance its electrical conductivity. It may also be understood that the transparent electrode may constitute a laminar structure of conducting layers (e.g. oxide/metal/polymer). Next to the transparent anode (301) are four organic layers, a hole-injection layer 302, a composite donor layer 303, an acceptor layer 304 and an exciton blocking layer 305. Next to the exciton blocking layer is a cathode 306. Light 308 enters the device through the transparent anode (301). The electrical load 307 is also illustrated.

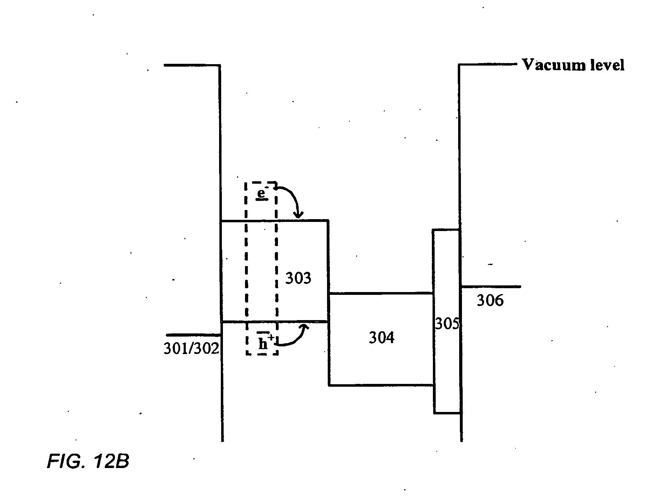

Figure 12B shows an energy level diagram corresponding to the organic solar cell device shown in Figure 12A. To simplify the diagram the hole-injection layer and ITO electrode are combined. When light is incident from the ITO glass side of the device it is absorbed by the donor and acceptor layers (303, 304) to form tightly bound electron-hole pairs (excitons). Excitons are mobile in the acceptor and donor layers. When excitons arrive at the donor-acceptor heterojunction they are dissociated to form free charges. The exciton blocking layer (305) reduces exciton quenching by the cathode (306) without retarding the flow of electrons to the cathode. Free charges formed at the donor-acceptor heterojunction are extracted to the external circuit via the electrodes (301, 306). In this embodiment the composite of adapted carbon nanotubes and organic semiconductor comprises the donor layer (303). In Figure 12B an adapted carbon nanotube within the semiconducting matrix of the donor layer is schematically illustrated by two discrete energy levels corresponding to a ground and excited electronic state of said carbon nanotube. It should be noted that the schematic in Figure 12B is greatly simplified with respect to the adapted MWCNT - In reality there is a distribution of ground and excited electronic states associated with adapted carbon nanotubes. It should also be noted that the adapted MWCNT in the current embodiment can be stimulated into an excited electronic state via single photon, or multi-photon absorption.

In this embodiment the ITO glass substrates are cleaned using a three-stage wet process comprising ultrasonic agitation in toluene, an aqueous solution of the surfactant Decon Neutracon and finally acetone, before drying in stream of nitrogen gas. The hole injecting layer (302), PEDOT:PSS, is spin cast onto the ITO substrate from a 1.3% aqueous solution and annealed for 15 minutes in air at 150°C. The nominal thickness of the PEDOT:PSS layer is 50 nm.

In this embodiment a composite material of adapted carbon nanotubes and organic semiconductor forms the donor layer in the device structure shown in Figure 12A. The composite material is produced from MWCNT oxidised in a 3:1 mixture of concentrated sulphuric and nitric acid to produce carboxylic acid and hydroxyl functionality on the nanotube surface, according to the procedure described in the first embodiment of this document. The dry acid treated MWCNT (0.9 g) are dispersed in 30 ml of neat thionyl chloride (SOCl₂) and refluxed for 22 hours, converting the carboxylic acids into acyl chlorides. Residual thionyl chloride is removed by vacuum evaporation (or washing with anhydrous tetrahydrofuran and filtration) and dried under vacuum. The resulting acid chloride functionalised carbon nanotubes are reacted with 1H,1H-Perfluoro-1-tetradecanol (CF₃(CF₂)₁₂CH₂OH) at 120°C for 48 hours with continuous stirring to form suitably adapted carbon nanotubes. In a typical reaction 20 mg of acid chloride functionalized MWCNT is reacted with 1g 1H,1H-Perfluoro-1-tetradecanol in 30 ml anhydrous chloroform. The adapted MWCNT are separated by vacuum filtration and repeated washing with anhydrous chloroform.

In this embodiment the adapted MWCNT are blended with a soluble pentacene precursor (PP) formed by the reaction of pentacene with N-sulfinylacetamide and methyltrioxorhenium in chloroform. In a typical reaction 1g of pentacene is added to 1.14g sulfinylacetamide and a catalytic amount, 0.009g, of methyltrioxorhenium in 60 ml of chloroform. The reaction mixture is refluxed for 2 days. The reaction yield is > 90% and the PP product is then purified by flash chromatography. The adapted MWCNT are blended with PP in chloroform (typically 9.5 mg ml⁻¹ PP: 0.5 mg ml⁻¹ adapted MWCNT) to form a composite solution. The composite solution is then spin-cast in a nitrogen atmosphere at 2000 r.p.m. onto an ITO substrate, pre-coated with a PEDOT:PSS hole-injecting layer, to form a film approximately 50 nm thick of adapted carbon nanotubes uniformly distributed within a PP matrix. In order to convert PP into pentacene the film is annealed at 150°C for 5 minutes in a nitrogen atmosphere. It will be understood that the composite film could be of any other appropriate thickness, for example from 10-200 nm. It will also be understood that the carbon nanotube loading is not defined.

In this example the semiconductor heterojunction is completed by vacuum deposition of the acceptor layer, followed by vacuum deposition of the exciton blocking layer and top electrode. It should however be understood that the acceptor layer could also be deposited from solution using a soluble electron acceptor, for example [6,6]-phenyl-C₆₁. In this embodiment the acceptor layer comprises a 50 nm layer of Buckminsterfullerene (C₆₀) which is deposited by vacuum evaporation. The exciton blocking layer comprises a 12 nm layer of 2,9-dimethyl-4,7-diphenyl-1,10-phenanthroline (BCP). The cathode comprises a 50 nm layer of aluminum. The C₆₀ and BCP are vacuum deposited at a rate of 0.2 nm s⁻¹. The A1 electrode is vacuum deposited at 0.5 nms⁻¹.

In this embodiment the semiconducting organic material is selected to facilitate efficient energy transfer from adapted carbon nanotubes to the semiconducting organic material, wherein the organic material is selected such that the energy gap formed by the HOMO and LUMO energy levels lies within the effective band gap of the adapted carbon nanotubes. In this embodiment adapted carbon nanotubes have two main functions: (i) to directly increase the amount of incident light harnessed to generate electricity via increased absorption, thereby increasing cell efficiency; (ii) to retard the photo-degradation of the organic matrix, thereby extending device lifetime.

### THIRD EMBODIMENT

The invention may also be utilised in an organic light-emitting diode (OLED), as described in this embodiment.

Organic light-emitting diodes comprise one or more semiconducting organic film(s) sandwiched between two electrodes. Each film may comprise a single compound or a composite of two or more different compounds.

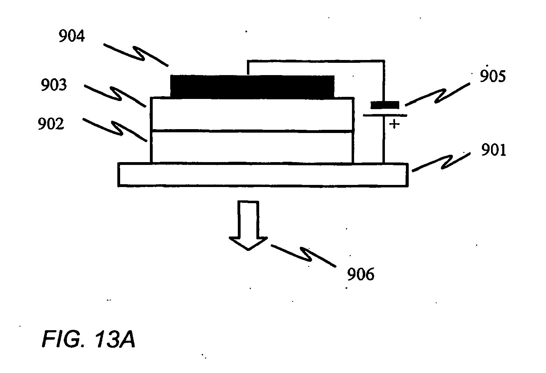

Figures 13A shows a schematic diagram of a multi-layer OLED device according to this embodiment. The device comprises a transparent anode 901, made of Indium-tin Oxide (ITO) coated glass with a sheet resistance of < 100 Ohms per square. The ITO coating on the glass substrate is typically 100-300 nm thick. Next to the transparent anode 901 are two organic layers, a hole-transport layer 902 and an emitter layer 903. In this embodiment the emitter layer comprises a composite of adapted carbon nanotubes and organic semiconductor. The device is completed by a low work function metal cathode 904. The external power supply 905 is also illustrated in the figure. Light 906 is produced in the emitter layer (903) and exits the device through the hole-transport layer (902) and ITO anode (901).

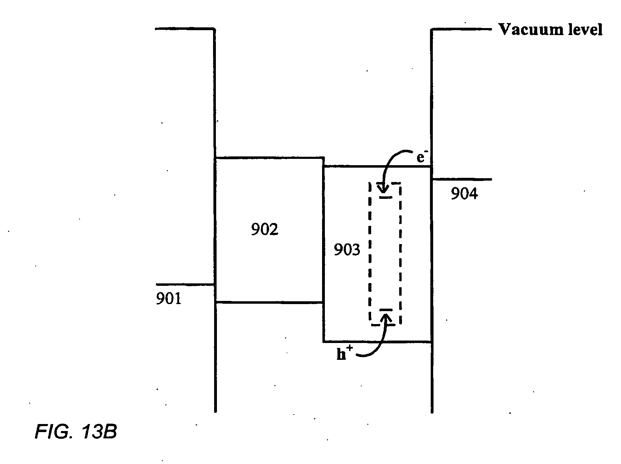

Figure 13B shows an energy level diagram corresponding to the OLED device shown in Figure 13A. When a forward bias is applied across the electrodes via an external power supply (905), holes are injected from the anode (901) into the hole-transport layer (902) and finally into composite emitter layer (903). Electrons are injected from the cathode (904) into the composite emitter layer (903). Electrons and holes are transported through the organic matrix of the emitter layer and recombine on adapted carbon nanotubes with the emission of light (906). It should be noted that the schematic in Figure 13B is greatly simplified with respect to the adapted MWCNT - In reality there is a distribution of ground and excited electronic states associated with adapted carbon nanotubes. Crucially, in this context the ground and excited states of the adapted carbon nanotubes, which subsequently relax with the emission of visible light, lie between the HOMO and LUMO energies of the organic host matrix. Light exits the device through the hole-transport layer (902) and anode (901).

The OLED employed in this embodiment comprises an ITO glass anode / 50 nm poly-TPD / 100 nm composite emitter /50 nm Ca, where poly-TPD is poly(N,N'-diphenylbenzidine diphenylether) and Ca is calcium. In this embodiment the ITO glass substrates are cleaned using a three-stage process comprising ultrasonic agitation in toluene, an aqueous solution of the surfactant Decon Neutracon and finally acetone, before drying in stream of nitrogen gas. This is followed by an oxygen-plasma treatment to remove residual carbon contamination. The poly-TPD layer is spin cast from a 0.2% w/w tetrahydrofuran solution.

The composite material is produced from MWCNT oxidised in a 3:1 mixture of concentrated sulphuric and nitric acid to produce carboxylic acid and hydroxyl functionality on the nanotube surface according to the procedure described in the first embodiment of this document. The dry acid treated MWCNT (0.9 g) are dispersed in 30 ml of neat thionyl chloride (SOCl₂) and refluxed for 22 hours, converting the carboxylic acids into acyl chlorides. Residual thionyl chloride is removed by vacuum evaporation (or washing with anhydrous tetrahydrofuran and filtration) and dried under vacuum. The resulting acid chloride functionalised carbon nanotubes are reacted with pentadecylamine at 120°C for 48 hours with continuous stirring to form suitably adapted carbon nanotubes. In a typical reaction 20 mg of acid chloride functionalized MWCNT is reacted with 0.5g pentadecylamine in 30 ml anhydrous chloroform. The adapted MWCNT are separated by vacuum filtration and repeated washing with anhydrous chloroform.

The adapted MWCNT are blended with poly(9,9-dioctylfluorene); PFO, in xylene (typically 14.25 mg ml⁻¹ PFO: 0.75 mg ml⁻¹ adapted MWCNT) to form a composite and spin cast onto a clean ITO glass substrate previously coated with the hole-transport layer. In this embodiment the composite film is approximately 100 nm thick. However, the film could be of any appropriate thickness, for example, from 10-100 nm. In this context the composite functions as the emitter layer. The Ca electrode is vacuum deposited at a rate of 0.5 nm s⁻¹.

In this embodiment the semiconducting organic material is selected to facilitate efficient energy transfer from to the semiconducting organic material to adapted carbon nanotubes, wherein the organic material is selected such that the effective band gap of the adapted carbon nanotubes lies within the energy gap formed by the HOMO and LUMO energy levels of the organic material. In this embodiment the organic host matrix comprises only one type of organic semiconductor. It should however be understood that the organic matrix may comprise a number of different organic semiconductors having different band gaps, in order to facilitate the emission of white light.

In this context carbon nanotubes have two main functions: (i) to emit visible light over a range of wavelengths; (ii) to retard the photo-degradation of the organic matrix, thereby extending device lifetime.

### FURTHER EMBODIMENTS

It will be understood that embodiments of the present invention are described herein by way of example only, and that various changes and modifications may be made without departing from the scope of the invention.

Further, it will be understood that modification or adaptation of carbon nanotubes to enhance their luminescent properties can be carried out using any suitable method, such as, for example, the following methods: The carbon nanotubes may be covalently functionalised on their outer surface using amide or ester linkages to couple organic functionality to the carbon nanotube surface.

It will be understood that the carbon nanotubes may be further functionalised by adapting or modifying their interior structure. For example, organic materials including molecular semiconductors may be inserted into the internal cavity of the carbon nanotube. The insertion of such a material changes the electronic properties of the carbon nanotube and so allows the carbon nanotube to be electronically tuned for its specific purpose.

It will be further understood that the carbon nanotubes may be doped by introducing interstitial or substitutional defects into the carbon nanotube, such as nitrogen or boron. Doping changes the electronic and optical properties of the carbon nanotube and so allows the carbon nanotube to be tuned for its specific purpose.

It will be understood that energy may be transferred between the organic matrix and carbon nanotube in either direction, depending on the device in which the composite material is to be utilised.

It will be understood that energy may be transferred between the organic matrix and carbon nanotube in either direction by; (i) the coherent transfer of an electron and hole pair (Dexter transfer); (ii) sequential transfer of an electron and hole (charge transfer); (iii) or resonant coupling transfer (Förster transfer). Further it will also be understood that the term *energy transfer* is used to mean complete or partial transfer of energy.

It will be understood that if the intended application of the composite of adapted carbon nanotubes and organic semiconductor is as a light harvester in organic solar cells, adapted carbon nanotubes are electronically excited by the absorption of light with subsequent complete, or partial, energy transfer to a surrounding organic matrix. In this context part, or all, of the organic matrix is selected on the basis that its ionization energy is less than or equal to 5.5 eV. Further, the energy gap between the HOMO and LUMO of the component of the organic matrix with ionization energy less than or equal to 5.5 eV, is less than or equal to 2.8 eV.

It will also be understood that if the intended application of the composite of adapted carbon nanotubes and organic semiconductor is as a light emitter in organic light emitting diodes, the organic semiconductor matrix is electrically excited and the energy is transferred, at least in part, to the adapted carbon nanotubes, which subsequently relaxes to the ground state with the emission of light. In this context part, or all, of the organic matrix is selected on the basis that its ionization energy is not less than 4.8 eV. Further, the energy gap between the HOMO and LUMO of the component of the organic matrix with ionization energy not less than 4.8 eV, is not less than 2.2 eV.

It will also be understood that suitable matrix materials may include: (i) Soluble derivatives of molecular semiconductors such as porphyrins, acenes or phthalocyanines; (ii) Soluble derivatives of conjugated polymers including polyphenylene vinylene, fluorene copolymers or polythiophene.

It will also be understood that the composites with carbon nanotubes described herein can be processed into a thin film suitable for application in organic electronic devices using any suitable process, for example: (i) spin coating; (ii) ink jet printing; (iii) screen printing; (iv) doctor blading.

It will be understood that, carbon nanotube composites with organic semiconductor materials maybe used in organic solar cells as the light harvesting layer.

It will be understood that, carbon nanotube composites with organic semiconductor materials maybe used in organic solar cells, having reduced susceptibility to photo-bleaching.

It will be understood that, carbon nanotube composites with organic semiconductor materials maybe used in organic light-emitting diodes as the light emitter.

It will be understood that, carbon nanotube composites with organic semiconductor materials maybe used in organic light-emitting diodes, having reduced susceptibility to photo-bleaching.

It will also be understood that carbon nanotube composites with organic semiconductor materials may be used in a gas sensing device comprising a solar cell structure, where the open circuit voltage, short circuit current and power conversion efficiency of the solar cell are dependent on the environment in which it is operating - That is, the fourth quadrant electrical response of the device upon illumination, gives an indication of the gas(es) in the surrounding environment. In this context the mechanism by which the electrical properties of the solar cell are altered is doping of the organic semi-conducting component(s) of the device by the gas. Crucially a gas sensor of this type provides its own electrical power making it ideally suited to utilisation in a system on a chip.

Other examples of devices in which a thin film as described above could be utilised are photo-detectors, any kind of light light-emitting device, or gas sensor.

## Claims

1. A method of producing a photo-voltaic device comprising the steps of:
synthesising carbon nanotubes; and
combining the carbon nanotubes and an organic semiconductor material to form a composite material,
adapting the synthesised carbon nanotubes to provide a surface defect such as to create an effective band gap defined by ground and excited electronic states;
selecting the organic semiconductor material to facilitate the efficient energy transfer between carbon nanotubes and the organic semiconductor material, **characterized in that** the organic semiconductor material is selected such that the HOMO and LUMO energy levels of the organic semiconductor material lie between the energy levels of the ground and excited electronic states of the adapted carbon nanotubes.

2. A method of producing a light emitting device comprising the steps of:
synthesising carbon nanotubes; and
combining the carbon nanotubes and an organic semiconductor material to form a composite material,
adapting the synthesised carbon nanotubes to provide a surface defect such as to create an effective band gap defined by ground and excited electronic states ;
selecting the organic semiconductor material to facilitate the efficient energy transfer from the organic material to the adapted carbon nanotubes, **characterized in that** the organic semiconductor material is selected such that the energy levels of the ground and excited electronic states of the adapted carbon nanotubes lie between the HOMO and LUMO energy levels of the organic semiconductor material.

3. The method of claim 1, further comprising the step of purifying the carbon nanotubes.

4. The method of claim 1, wherein energy is transferred between the carbon nanotubes and the organic matrix by the coherent transfer of an electron and hole pair, by the sequential transfer of an electron and hole, and/or by resonant coupling transfer.

5. The method of claim 1, wherein the combining step comprises synthesis of the organic material in-situ with the carbon nanotubes.

6. The method of claim 1, wherein the adaptation step further includes adapting the carbon nanotubes to enhance the luminescent properties.

7. The method of claim 1, wherein the adaptation step comprises a covalent bonding method during the combining step.

8. The method of claim 7, wherein the carbon nanotubes are adapted using amide or ester linkages.

9. The method of claim 1, wherein the adaptation step comprises a non-covalent bonding method during the combining step.

10. The method of claim 1, wherein the adaptation step comprises a substitutional doping step.

11. The method of claim 1, wherein the adaptation step comprises a interstitial doping step.

12. The method of claim 1, wherein the adaptation step comprises adapting the interior structure of the carbon nanotubes.

13. The method of claim 1, wherein the organic material is selected from organic materials that have an ionization energy less than or equal to 5.5 electron volts.

14. The method of claim 13, wherein the organic material is selected from organic materials having a HOMO-LUMO gap less than or equal to 2.8 electron volts.

15. The method of claim 2, wherein the organic material is selected from organic materials that have an ionization energy greater than or equal to 4.8 electron volts.

16. The method of claim 1 further comprising the step of processing the composite material to form a thin film.

17. A photo-voltaic device comprising carbon nanotubes embedded in an organic semiconductor material, the carbon nanotubes being adapted to provide a surface defect such as to create an effective band gap defined by ground and excited electronic states, **characterized in that** the HOMO and LUMO energy levels of the organic semiconductor material lie between the energy levels of the ground and excited electronic states of the adapted carbon nanotubes.

18. A light emitting device comprising carbon nanotubes embedded in an organic semiconductor material, the carbon nanotubes being adapted to provide a surface defect such as to create an effective band gap defined by ground and excited electronic states, **characterized in that** the energy levels of the ground and excited electronic states of the adapted carbon nanotubes lie between the HOMO and LUMO energy levels of the organic semiconductor material.

## Patentansprüche

1. Verfahren zum Herstellen einer Fotovoltaikeinrichtung umfassend die folgenden Schritte:
Synthetisieren von Kohlenstoffnanoröhrchen und
Kombinieren der Kohlenstoffnanoröhrchen und eines organischen Halbleitermaterials zum Ausbilden eines Composite-Materials,
Anpassen der synthetisierten Kohlenstoffnanoröhrchen, um einen Oberflächendefekt zu liefern, so dass ein durch Grund- und angeregten Elektronenzustand definierter effektiver Bandabstand erzeugt wird;
Wählen des organischen Halbleitermaterials, um den effizienten Energietransfer zwischen den Kohlenstoffnanoröhrchen und dem organischen Halbleitermaterial zu erleichtern,
**dadurch gekennzeichnet, dass** das organische Halbleitermaterial derart gewählt wird, dass die HOMO- und LUMO-Energieniveaus des organischen Halbleitermaterials zwischen den Energieniveaus des Grund- und angeregten Elektronenzustands der angepassten Kohlenstoffnanoröhrchen liegen.

2. Verfahren zum Herstellen einer lichtemittierenden Einrichtung umfassend die folgenden Schritte:
Synthetisieren von Kohlenstoffnanoröhrchen und
Kombinieren der Kohlenstoffnanoröhrchen und eines organischen Halbleitermaterials zum Ausbilden eines Composite-Materials,
Anpassen der synthetisierten Kohlenstoffnanoröhrchen, um einen Oberflächendefekt zu liefern, so dass ein durch Grund- und angeregten Elektronenzustand definierter effektiver Bandabstand erzeugt wird;
Wählen des organischen Halbleitermaterials, um den effizienten Energietransfer von dem organischen Material zu den angepassten Kohlenstoffnanoröhrchen zu erleichtern,
**dadurch gekennzeichnet, dass** das organische Halbleitermaterial derart gewählt wird, dass die Energieniveaus des Grund- und des angeregten Elektronenzustands der angepassten Kohlenstoffnanoröhrchen zwischen den HOMO- und LUMO-Energieniveaus des organischen Halbleitermaterials liegen.

3. Verfahren nach Anspruch 1, weiterhin umfassend den Schritt des Aufreinigens der Kohlenstoffnanoröhrchen.

4. Verfahren nach Anspruch 1, wobei die Energie zwischen den Kohlenstoffnanoröhrchen und der organischen Matrix durch den kohärenten Transfer eines Elektronen-Loch-Paars, durch den sequenziellen Transfer eines Elektrons und Lochs und/oder durch Resonanzkopplungstransfer transferiert wird.

5. Verfahren nach Anspruch 1, wobei der Kombinierungsschritt eine Synthese des organischen Materials in situ mit den Kohlenstoffnanoröhrchen umfasst.

6. Verfahren nach Anspruch 1, wobei der Anpassungsschritt weiterhin das Anpassen der Kohlenstoffnanoröhrchen beinhaltet, um die Lumineszenzeigenschaften zu verstärken.

7. Verfahren nach Anspruch 1, wobei der Anpassungsschritt während des Kombinierungsschritts ein kovalentes Bindungsverfahren umfasst.

8. Verfahren nach Anspruch 7, wobei die Kohlenstoffnanoröhrchen unter Verwendung von Amid- oder Esterbindungen angepasst werden.

9. Verfahren nach Anspruch 1, wobei der Anpassungsschritt während des Kombinierungsschritts ein nicht-kovalentes Bindungsverfahren umfasst.

10. Verfahren nach Anspruch 1, wobei der Anpassungsschritt einen Substitutionsdotierungsschritt umfasst.

11. Verfahren nach Anspruch 1, wobei der Anpassungsschritt einen Einlagerungsdotierungsschritt umfasst.

12. Verfahren nach Anspruch 1, wobei der Anpassungsschritt das Anpassen der Innenstruktur der Kohlenstoffnanoröhrchen umfasst.

13. Verfahren nach Anspruch 1, wobei das organische Material ausgewählt ist unter organischen Materialien mit einer Ionisierungsenergie kleiner oder gleich 5,5 Elektronenvolt.

14. Verfahren nach Anspruch 13, wobei das organische Material ausgewählt ist unter organischen Materialien mit einem HOMO-LUMO-Abstand kleiner oder gleich 2,8 Elektronenvolt.

15. Verfahren nach Anspruch 2, wobei das organische Material ausgewählt ist unter organischen Materialien mit einer Ionisierungsenergie größer oder gleich 4,8 Elektronenvolt.

16. Verfahren nach Anspruch 1, weiterhin umfassend den Schritt des Verarbeitens des Composite-Materials, um einen dünnen Film auszubilden.

17. Fotovoltaikeinrichtung umfassend in ein organisches Halbleitermaterial eingebettete Kohlenstoffnanoröhrchen, wobei die Kohlenstoffnanoröhrchen dafür angepasst sind, einen Oberflächendefekt zu liefern, so dass ein durch Grund- und angeregten Elektronenzustand definierter effektiver Bandabstand erzeugt wird;
**dadurch gekennzeichnet, dass** die HOMO- und LUMO-Energieniveaus des organischen Halbleitermaterials zwischen den Energieniveaus des Grund- und angeregten Elektronenzustands der angepassten Kohlenstoffnanoröhrchen liegen.

18. Lichtemittierende Einrichtung umfassend in ein organisches Halbleitermaterial eingebettete Kohlenstoffnanoröhrchen, wobei die Kohlenstoffnanoröhrchen dafür angepasst sind, einen Oberflächendefekt zu liefern, so dass ein durch Grund- und angeregten Elektronenzustand definierter effektiver Bandabstand erzeugt wird;
**dadurch gekennzeichnet, dass** die Energieniveaus des Grund- und angeregten Elektronenzustands der angepassten Kohlenstoffnanoröhrchen zwischen den HOMO- und LUMO-Energieniveaus des organischen Halbleitermaterials liegen.

## Revendications

1. Méthode de production d'un dispositif photovoltaïque comprenant les étapes consistant à :
synthétiser des nanotubes de carbone ; et
combiner les nanotubes de carbone et un matériau semi-conducteur organique pour former un matériau composite,
adapter les nanotubes de carbone synthétisés pour réaliser un défaut de surface afin de créer une bande interdite efficace définie par des états électroniques fondamental et excité ;
sélectionner le matériau de semi-conducteur organique pour permettre une transmission d'énergie efficace entre les nanotubes de carbone et le matériau semi-conducteur organique, **caractérisé en ce que** le matériau semi-conducteur organique est sélectionné pour que les niveaux d'énergie HOMO et LUMO du matériau semi-conducteur organique se situent entre les niveaux d'énergie des états électroniques fondamental et excité des nanotubes de carbone adaptés.

2. Procédé de production d'un dispositif électroluminescent comprenant les étapes consistant à :
synthétiser des nanotubes de carbone ; et
combiner les nanotubes de carbone et un matériau semi-conducteur organique pour former un matériau composite,
adapter les nanotubes de carbone synthétisés pour réaliser un défaut de surface afin de créer une bande interdite efficace définie par des états électroniques fondamental et excité ;
sélectionner le matériau de semi-conducteur organique pour permettre une transmission d'énergie efficace du matériau organique aux nanotubes de carbone adaptés, **caractérisé en ce que** le matériau semi-conducteur organique est sélectionné pour que les niveaux d'énergie des états électroniques fondamental et excité des nanotubes de carbone adaptés se situent entre les niveaux d'énergie HOMO et LUMO du matériau semi-conducteur organique.

3. Procédé selon la revendication 1, comprenant en outre l'étape consistant à purifier les nanotubes de carbone.

4. Procédé selon la revendication 1, dans lequel l'énergie est transférée entre les nanotubes de carbone et la matrice organique par la transmission cohérente d'une paire « électron-trou », par la transmission séquentielle d'un électron et trou, et/ou au moyen d'une transmission par couplage résonnant.

5. Procédé selon la revendication 1, dans lequel l'étape de combinaison comprend la synthèse du matériau organique in-situ avec les nanotubes de carbone.

6. Procédé selon la revendication 1, dans lequel l'étape d'adaptation comprend en outre l'adaptation des nanotubes de carbone pour renforcer les propriétés luminescentes.

7. Procédé selon la revendication 1, dans lequel l'étape d'adaptation comprend un procédé de liaison covalente pendant l'étape de combinaison.

8. Procédé selon la revendication 7, dans lequel les nanotubes de carbone sont adaptés au moyen de liaisons amide ou ester.

9. Procédé selon la revendication 1, dans lequel l'étape d'adaptation comprend un procédé de liaison non-covalente pendant l'étape de combinaison.

10. Procédé selon la revendication 1, dans lequel l'étape d'adaptation comprend une étape de dopage substitutionnel.

11. Procédé selon la revendication 1, dans lequel l'étape d'adaptation comprend une étape de dopage interstitiel.

12. Procédé selon la revendication 1, dans lequel l'étape d'adaptation comprend l'adaptation de la structure intérieure des nanotubes de carbone.

13. Procédé selon la revendication 1, dans lequel le matériau organique est sélectionné parmi des matériaux organiques présentant une énergie d'ionisation inférieure ou égale à 5,5 électronvolts.

14. Procédé selon la revendication 13, dans lequel le matériau organique est sélectionné parmi des matériaux organiques présentant une différence d'énergie HOMO-LUMO inférieure ou égale à 2,8 électronvolts.

15. Procédé selon la revendication 2, dans lequel le matériau organique est sélectionné parmi des matériaux organiques présentant une énergie d'ionisation supérieure ou égale à 4,8 électronvolts.

16. Procédé selon la revendication 1, comprenant en outre l'étape consistant à traiter le matériau composite pour former une pellicule mince.

17. Dispositif photovoltaïque comprenant des nanotubes de carbone imbriqués dans un matériau semi-conducteur organique, les nanotubes de carbone étant adaptés pour réaliser un défaut de surface de manière à créer une bande interdite efficace définie par des états électroniques fondamental et excité, **caractérisé en ce que** les niveaux d'énergie HOMO et LUMO du matériau semi-conducteur organique se situent entre les niveaux d'énergie des états électroniques fondamental et excité des nanotubes de carbone adaptés.

18. Dispositif électroluminescent comprenant des nanotubes de carbone imbriqués dans un matériau semi-conducteur organique, les nanotubes de carbone étant adaptés pour réaliser un défaut de surface de manière à créer une bande interdite efficace définie par des états électroniques fondamental et excité, **caractérisé en ce que** les niveaux d'énergie des états électroniques fondamental et excité des nanotubes de carbone adaptés se situent entre les niveaux d'énergie HOMO et LUMO du matériau semi-conducteur organique.
